# FASCICULE DE BREVET EUROPEEN

(11) **EP 2 095 140 B1**
(45) Date de publication et mention de la délivrance du brevet: **10.10.2018**
(21) Numéro de dépôt: 07858698.9
(22) Date de dépôt: 15.11.2007
(51) Int. Cl.: G01R 29/08

(54) **DISPOSITIF DE MESURE DU CHAMP ELECTROMAGNETIQUE EMIS PAR UN APPAREIL SOUS TEST**
MESSGERÄT FÜR DAS VON EINER ÜBERPRÜFTEN VORRICHTUNG AUSGEHENDE ELEKTROMAGNETISCHE FELD
MEASURING DEVICE FOR THE ELECTROMAGNETIC FIELD EMITTED BY AN APPARATUS BEING TESTED

(30) Priorité: 01.12.2006 FR 0655261
(43) Date de publication de la demande: 02.09.2009
(73) Titulaire: Institut Français des Sciences et Technologies des Transports, de l'Amenagement et des Reseaux, 77420 Champs sur Marne (FR)
(72) Inventeur: RIOULT, Jean, 59000 Lille (FR); HEDDEBAUT, Marc, 59262 Sainghin En Melantois (FR); COLLINS-DENIAU, Virginie, 59194 Raches (FR)
(74) Mandataire: Thibault, Jean-Marc
(86) Numéro de dépôt international: PCT/FR2007/052342
(87) Numéro de publication internationale: WO 2008/065290

(56) Documents cités:
- US-A1- 2002 075 189
- ALTMAN Z ET AL: "Spherical Near Field Facility for Characterizing Random Emissions" IEEE TRANSACTIONS ON ANTENNAS AND PROPAGATION, IEEE SERVICE CENTER, PISCATAWAY, NJ, US, vol. 53, no. 8, août 2005 (2005-08), pages 2582-2589, XP011137410 ISSN: 0018-926X cité dans la demande

## Description

La présente invention se rapporte à la mesure du champ électromagnétique émis par un appareil sous test.

Le document « Spherical Near Field Facility for Characterizing Random Emissions », IEEE transactions on antennas and propagation, p. 2582, vol. 53, NO. 8, août 2005, décrit un dispositif de mesure du champ électromagnétique émis par un appareil sous test. Ce dispositif comprend deux demi-arcs, dont l'un est apte à tourner autour de l'appareil sous test, sur lesquels sont fixés des capteurs électromagnétiques. Les signaux captés par les capteurs électromagnétiques sont enregistrés et traités par un ordinateur. Ces opérations sont relativement longues et réalisées en temps différé. Le traitement effectué sur l'ordinateur permet notamment d'obtenir une représentation graphique du champ émis par l'appareil sous test sur l'écran de l'ordinateur. Il est nécessaire de faire une hypothèse sur le champ émis par l'appareil sous test pour choisir et calibrer les capteurs électromagnétiques. Si après la mesure on se rend compte que le choix était mauvais, il faut recommencer toutes les opérations.

US2002/0075189 décrit un dispositif de mesure du champ électromagnétique comprenant une source de lumière pour indiquer le champ électromagnétique mesuré, mais sans mouvement ou rotation du dispositif.

L'invention a pour but de fournir un dispositif qui ne présente pas au moins certains des inconvénients précités de l'art antérieur.

Pour cela, l'invention fournit un dispositif de mesure du champ électromagnétique émis par un appareil sous test, comprenant un support mobile par rapport audit appareil sous test, au moins un capteur électromagnétique fixé audit support et des moyens d'entraînement aptes à entraîner ledit support en rotation autour dudit appareil sous test, caractérisé par le fait qu'il comprend au moins une source de lumière fixée adjacente audit capteur électromagnétique et émettant de la lumière en fonction du champ électromagnétique mesuré par ledit capteur électromagnétique.

Ce dispositif permet donc d'obtenir une visualisation directe, c'est-à-dire sans nécessiter un écran, du champ électromagnétique émis par l'appareil sous test. De plus, cette visualisation est réalisée en temps réel. Aucun traitement informatique n'est nécessaire. Dans un mode de réalisation particulier, cette visualisation directe prend la forme d'une sphère lumineuse dont la couleur et/ou l'intensité en un point donné dépend du champ électromagnétique émis par l'appareil sous test dans la direction correspondant à ce point.

De préférence, le dispositif comprend une pluralité de capteurs électromagnétiques fixés au support, et une pluralité de sources de lumière adjacentes respectivement à un des capteurs électromagnétiques et aptes à émettre de la lumière en fonction du champ électromagnétique mesuré par le capteur électromagnétique adjacent. Par exemple, chaque capteur comprend au moins une antenne mettant en évidence soit le champ électrique soit le champ magnétique local. Chaque capteur est réalisé de préférence de façon à mesurer un champ local tel qu'il existerait en l'absence de capteur.

Ainsi le dispositif permet d'obtenir une visualisation du champ électromagnétique émis par l'appareil sous test dans une pluralité de directions différentes.

Avantageusement, la source de lumière est agencée de manière à émettre de la lumière dans une direction opposée audit appareil sous test.

Selon un mode de réalisation particulier, la source de lumière est apte à émettre de la lumière depuis une surface variable en fonction du champ électromagnétique mesuré par le capteur électromagnétique.

En fonction de l'agencement de la surface variable, cela permet de représenter le champ électromagnétique par un volume.

De préférence, les moyens d'entraînement sont aptes à entraîner le support en rotation autour dudit appareil sous test à une vitesse suffisante pour que la fréquence de passage d'un moins une source de lumière en un point donné soit supérieure à 24 Hz.

Ainsi, grâce à la persistance rétinienne humaine, un observateur peut visualiser le champ électromagnétique sous la forme d'un cercle ou d'une surface de révolution (en fonction du nombre et de l'agencement des sources de lumière). Bien entendu, l'invention n'est pas limitée à de telles fréquences de passage. A une fréquence de passage inférieure, l'observateur peut visualiser un cercle ou une surface lumineuse avec un effet de papillotement.

Avantageusement, le capteur électromagnétique et la source de lumière sont agencés dans un boîtier apte à être fixé sur le support.

Dans ce cas le montage ou le remplacement d'un capteur et d'une source de lumière est réalisé par une même opération. Le boîtier peut par exemple être fixé sur le support par clipsage.

Selon un mode de réalisation particulier, le support présente des pistes électriques, le boîtier présentant des contacteurs en contact avec les pistes. Les pistes peuvent être des pistes d'alimentation et/ou de communication.

Selon un mode de réalisation particulier, le support présente au moins une portion de forme circulaire, les moyens d'entraînement étant agencés de sorte que la rotation du support génère une surface sensiblement sphérique. Le support peut par exemple être un cercle complet ou un demi-cercle. On préfère le premier cas pour des raisons d'équilibrage des pièces en rotation, et parce qu'il nécessite une vitesse de rotation deux fois moins élevée pour obtenir l'effet précité de persistance rétinienne.

Selon un autre mode de réalisation, le support présente une portion de forme rectiligne, les moyens d'entraînement étant agencés de sorte que la rotation du support génère une surface sensiblement cylindrique de révolution.

Avantageusement, le dispositif comprend un plateau pour ledit appareil sous test, le plateau étant fixé à l'extrémité d'un tube creux.

Dans ce cas il est possible de faire passer un câble d'alimentation de l'appareil sous test par le tube creux.

Selon un mode de réalisation particulier, le dispositif comprend une armature fixe à laquelle est relié le support par l'intermédiaire de paliers creux.

Quand l'appareil sous test est un connecteur reliant deux câbles, les paliers creux permettent de faire passer les câbles.

Selon un mode de réalisation particulier, le dispositif comprend une cage réalisée au moins partiellement en matériau transparent, le support étant agencé dans ladite cage. La cage offre une protection sans nuire sensiblement à la visualisation du champ.

De préférence, la source de lumière est reliée au capteur électromagnétique par l'intermédiaire de moyens de conversion. Les moyens de conversion comprennent par exemple un filtre permettant de mettre en évidence certaines fréquences d'intérêt, un circuit intégré apte à transformer le signal en provenance du capteur électromagnétique en un ou plusieurs signaux de commande de la source lumineuse, par exemple pour en commander la couleur ou l'intensité, un commutateur d'état,...

Avantageusement, les moyens de conversion sont commutables entre plusieurs états, le dispositif de mesure comprenant des moyens de commande aptes à communiquer avec les moyens de conversion par l'intermédiaire de moyens de communication pour commuter les moyens de conversion. Par exemple, les moyens de conversion peuvent être commandés pour que la source lumineuse soit allumée ou éteinte en fonction de la position du support ou en fonction du temps, pour modifier leur calibrage, pour prendre en compte une composante particulière du champ, pour modifier les caractéristiques d'un filtre de fréquences,...

Selon un mode de réalisation particulier, les moyens de conversion sont choisis en fonction d'une norme de compatibilité électromagnétique, le dispositif de mesure comprenant une source de signal reliée aux moyens de conversion et apte à émettre un signal de non-conformité quand le champ électromagnétique mesuré par le capteur électromagnétique indique que l'appareil sous test n'est pas conforme à ladite norme. Le signal de non-conformité peut par exemple être l'émission d'une couleur particulière par la source de lumière, ou l'émission d'un signal sonore par le dispositif.

L'invention fournit aussi une utilisation d'un dispositif selon l'invention précité, comprenant le fait d'entraîner le support en rotation autour dudit appareil sous test à une vitesse suffisante pour que la fréquence de passage d'un moins une source de lumière en un point donné soit supérieure à 24 Hz.

L'invention fournit aussi une utilisation d'un dispositif selon l'invention précité, comprenant le fait de vérifier si un appareil sous test est conforme à ladite norme, puis le fait de remplacer le support par un deuxième support dans lequel lesdits moyens de conversion sont choisis en fonction d'une deuxième norme, et vérifier si ledit appareil sous test est conforme à ladite deuxième norme. Cela permet de facilement vérifier la conformité à une norme particulière. Aucun réglage n'est nécessaire, il suffit de changer de support en fonction de la norme en question.

L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés. Sur ces dessins :
- la figure 1 est une vue en perspective d'un dispositif de mesure selon un mode de réalisation de l'invention,
- la figure 2 est une vue en perspective du dispositif de la figure 1, utilisé pour tester un connecteur,
- la figure 3 est une vue en perspective d'un détail du dispositif de la figure 1,
- la figure 4 est une vue en perspective d'un boîtier du dispositif de la figure 1,
- la figure 5 est une vue partielle et en perspective du support d'un dispositif de mesure selon un deuxième mode de réalisation de l'invention,
- la figure 6 est une vue en perspective d'un boîtier du dispositif de la figure 5, dont la paroi de dessus a été enlevée.

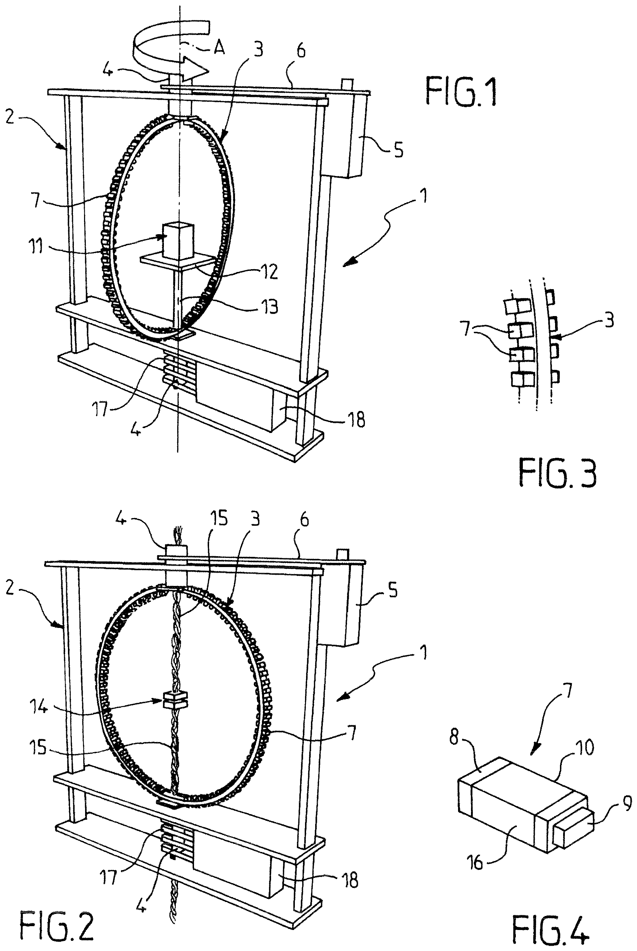

Le dispositif de mesure 1 de la figure 1 comprend une armature 2 de forme globalement rectangulaire. Un support 3 en forme d'anneau est relié à l'armature 2 par deux paliers 4 de manière à pouvoir tourner autour d'un axe A. Le palier 4 supérieur est relié à un moteur 5, par exemple un moteur électrique, par l'intermédiaire d'une courroie 6. Le moteur 5 est apte à entraîner le support 3 en rotation à une vitesse de 12 tours/s (ou plus).

Une pluralité de boîtiers 7 sont fixés au support 3, répartis sur sa circonférence. Les boîtiers 7 sont par exemple insérés dans des encoches ménagées dans le support 3, comme le montre la figure 3. Un boîtier 7 est représenté plus en détail sur la figure 4. Il comprend un capteur électromagnétique 8 du côté tourné vers le centre du support 3, une source de lumière 9 du côté opposé au centre du support 3, et des moyens de conversion 10 qui relient le capteur électromagnétique 8 à la source de lumière 9. Ainsi, la source de lumière 9 émet de la lumière dans une direction opposée au centre du support 3, en fonction du champ électromagnétique capté par le capteur électromagnétique 8.

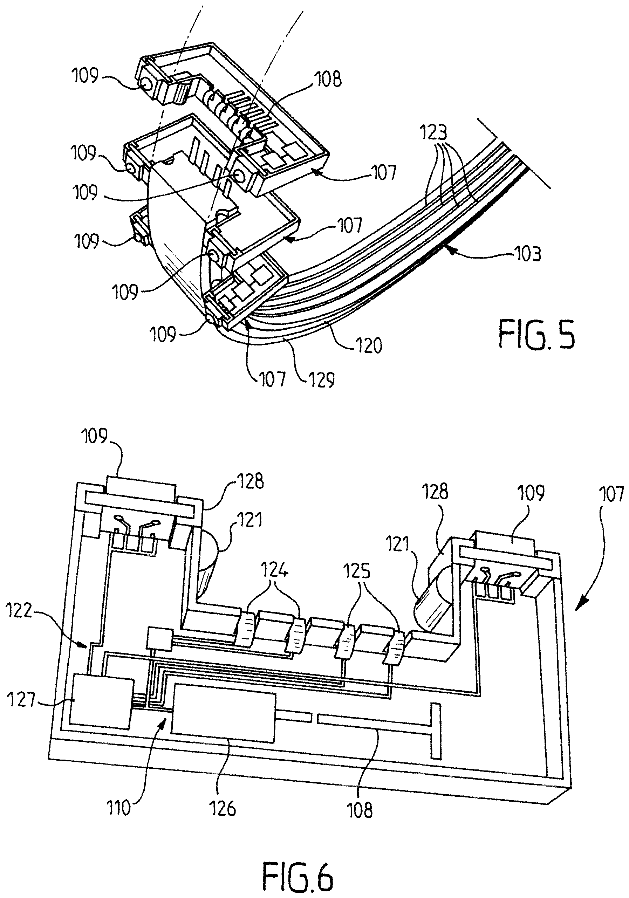

Un exemple de réalisation pour le capteur électromagnétique 8, la source de lumière 9 et les moyens de conversion 10 est donné ci-dessous, en référence au mode de réalisation des figures 5 et 6. Bien entendu, l'invention n'est pas limitée à cet exemple. Par exemple, la source de lumière 9 pourrait être agencée sur une face latérale 16 du boîtier 7, et émettre de la lumière depuis une surface variable en fonction du champ électromagnétique capté par le capteur électromagnétique 8. Cela permet de représenter le champ par un volume. Selon une autre variante, le capteur électromagnétique 8, la source de lumière 9 et les moyens de conversion 10 ne sont pas réunis dans un même boîtier.

Le palier 4 inférieur présente des bagues (non représentées) en contact avec des balais 17, ce qui permet d'assurer une liaison électrique entre les boîtiers 7 et un panneau de commande 18. Le panneau de commande 18 peut ainsi alimenter les boîtiers 7 en électricité et/ou leur envoyer des signaux de commande. Les fonctions des signaux de commande seront décrites en référence au mode de réalisation des figures 5 et 6.

Un plateau 12 est fixé à une extrémité d'un tube creux 13, légèrement en dessous du centre du support 3. Ainsi, quand on place un appareil à tester sur le plateau 12, par exemple un téléphone cellulaire 11, celui-ci se trouve au centre du support 3, donc à distance égale des capteurs électromagnétiques 8. Le tube creux 13 permet de faire passer un câble (non représenté) pour l'alimentation électrique et/ou la commande de l'appareil sous test.

Le tube creux 13 et le plateau 12 sont amovibles et les paliers 4 sont creux. Comme représenté sur la figure 2 cela permet, dans le cas où l'appareil à tester est un connecteur 14, de faire passer les câbles 15 reliés par le connecteur 14.

On décrit maintenant le fonctionnement général du dispositif de mesure 1. Des aspects particuliers de fonctionnement seront décrits en référence au mode de réalisation des figures 5 et 6.

Un appareil à tester, par exemple un téléphone cellulaire 11 ou un connecteur 14, est placé sensiblement au centre du support 3. Ensuite, le moteur 5 est actionné et entraîne le support 3 en rotation à une vitesse de 12 tours/s. Chaque capteur électromagnétique 8 capte le champ émis par l'appareil sous test dans une direction particulière correspondant à sa position sur le support 3 et à la position du support 3 par rapport à l'armature 2, et la source de lumière 9 associée émet de la lumière qui dépend du champ capté. Par exemple, la couleur et/ou l'intensité de la lumière émise est fonction du champ capté par le capteur électromagnétique 8 associé. Etant donné que le support 3 tourne, la position des capteurs électromagnétiques 8 varie. Le champ capté par un capteur 8 particulier varie donc également (sauf dans le cas particulier où le champ est uniforme), et la lumière émise aussi. Le temps de réponse du capteur électromagnétique 8 et de la source de lumière 9 est faible par rapport à la vitesse de rotation du support 12 de sorte que la lumière émise par une source de lumière 9 en un point particulier correspond au champ électromagnétique capté en ce point particulier.

Comme des boîtiers 7 sont répartis sensiblement sur toute la circonférence du support 3, et que celui-ci tourne à une vitesse de 12 tours/s, une source de lumière 9 passe en un point donné au moins 24 fois par seconde. En raison de la persistance rétinienne humaine, un observateur situé à côté du dispositif de mesure 1 perçoit alors une sphère lumineuse générée par les sources de lumière 9, dont la couleur et/ou l'intensité en un point donné correspond au champ électromagnétique émis par l'appareil sous test dans la direction de ce point. Bien entendu, en fonction de la forme du support, du nombre de boîtiers et de leur répartition sur le support, d'autres formes pourraient être produites, par exemple un cylindre de révolution ou un cercle.

Sur les figures 5 et 6, on a désigné des éléments identiques ou similaires à des éléments du mode de réalisation des figures 1 à 4 par les mêmes numéros de référence, augmentés de 100. Certains de ces éléments ne seront plus décrits en détail.

Le dispositif de mesure du mode de réalisation des figures 5 et 6 se différencie notamment par la forme des boîtiers 107. Un boîtier 107 présente, en vue de dessus, une forme globalement en U, et deux plots 121 sont agencés sur les faces internes 128 des branches du U. Le support 103 présente, sur chacune de ses faces latérales 129, une rainure 120. Les boîtiers 107 sont fixés au support 103 par clipsage, en insérant les plots 121 dans les rainures 120.

Un circuit imprimé 122 est agencé à l'intérieur du boîtier 107. Le capteur électromagnétique 108 est réalisé sous la forme d'une piste imprimée du circuit imprimé 122, qui forme une antenne. Les figures 5 et 6 illustrent deux formes possibles pour la piste imprimée du capteur électromagnétique 108. Le boîtier 107 comprend deux sources de lumière 109 agencées respectivement aux extrémités des branches du U. Chaque source de lumière 109 comprend trois diodes électroluminescentes de couleur rouge, vert et bleu, ce qui permet d'émettre de la lumière selon une grande variété de couleurs, en combinant la lumière de chaque diode.

Les moyens de conversion 110 qui relient le capteur électromagnétique 108 aux sources de lumière 109 comprennent des pistes du circuit imprimé 122, un circuit intégré de conversion 126 et une unité logique 127. Le circuit intégré de conversion 126 est apte à transformer le signal capté par le capteur électromagnétique 108 en un signal numérique qu'il transmet à l'unité logique 127. L'unité logique 127 est apte à transformer ce signal numérique en un signal de commande des sources de lumière 109. Dans un mode de réalisation non représenté, un filtre fréquentiel est inséré entre le capteur électromagnétique 108 et le circuit intégré de conversion 126, ce qui permet de ne visualiser qu'une bande de fréquences particulière du champ électromagnétique.

Le boîtier 107 présente deux contacteurs d'alimentation 124 qui sont en contact avec deux pistes 123 présentes sur le support 103, ce qui permet d'alimenter le circuit imprimé 122 en énergie.

Dans le mode de réalisation représenté, le boîtier 107 présente également deux contacteurs de signal de commande 125 qui sont en contact avec deux autres pistes 123. Les contacteurs 125 permettent une communication entre des moyens de commande (non représentés et par exemple situé dans le panneau de commande) et les moyens de conversion 110. Cette communication est effectuée en mettant en oeuvre un protocole de communication, par exemple du type bus I2C, sur les pistes 123. Bien entendu, d'autres moyens de communication peuvent être envisagés, par exemple une communication sans fils, pour autant que cette communication sans fils utilise une bande de fréquences distincte de celle captée par le capteur électromagnétique 108.

La communication entre les moyens de commande et le circuit imprimé 122 permet de réaliser une ou plusieurs fonctions, par exemple :
- modifier la bande passante du filtre fréquentiel,
- modifier le calibrage du circuit intégré de conversion 126,
- modifier le réglage de d'unité logique 127 pour modifier les couleurs et/ou l'intensité de la lumière,
- activer les sources de lumière 109 uniquement quand elles se trouvent dans des positions particulières, correspondant par exemple à un angle solide donné,
- activer les sources de lumière 109 uniquement à des instants particuliers, correspondant par exemple à l'émission d'un parasite par l'appareil sous test,
- dans le cas ou le capteur électromagnétique 108 comprend plusieurs antennes, sélectionner une de ces antennes pour mesurer une composante particulière du champ magnétique (par exemple composante électrique E ou composante magnétique H),
- commander les sources de lumière 109 pour émettre de la lumière en fonction d'un champ enregistré, à la place du champ mesuré.

Dans un mode de réalisation, le dispositif de mesure comprend en outre un pointeur qu'un utilisateur peut prendre en main et diriger vers la surface lumineuse générée par le dispositif de mesure en fonctionnement. Le pointeur comprend un capteur de lumière et un écran d'affichage. Quand l'utilisateur dirige le pointeur vers un point particulier de la surface lumineuse, le pointeur affiche sur son écran une ou plusieurs valeur(s) numérique(s) correspondant au champ électromagnétique qui correspond à la lumière émise en ce point particulier. Bien entendu, le pointeur est en communication avec les moyens de commande du dispositif de mesure pour connaître les réglages des moyens de conversion 10 ou 110 et ainsi afficher des valeurs numériques correctes.

Dans un mode de réalisation, le dispositif de mesure comprend plusieurs supports mobiles, situés à des distances différentes de l'appareil sous test, et qui permettent par exemple de visualiser chacun une bande de fréquences particulière du champ électromagnétique.

Bien que l'invention ait été décrite en liaison avec plusieurs modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

## Revendications

1. Dispositif de mesure (1) du champ électromagnétique émis par un appareil sous test (11, 14), comprenant un support (3, 103) mobile par rapport audit appareil sous test, au moins un capteur électromagnétique (8, 108) fixé audit support et des moyens d'entraînement (5, 6) aptes à entraîner ledit support en rotation autour dudit appareil sous test, **caractérisé par le fait qu'**il comprend au moins une source de lumière (9, 109) fixée adjacente audit capteur électromagnétique et émettant de la lumière en fonction du champ électromagnétique mesuré par ledit capteur électromagnétique.

2. Dispositif selon la revendication 1, comprenant une pluralité de capteurs électromagnétiques fixés audit support, et une pluralité de sources de lumière adjacentes respectivement à un desdits capteurs électromagnétiques et aptes à émettre de la lumière en fonction du champ électromagnétique mesuré par le capteur électromagnétique adjacent.

3. Dispositif selon l'une des revendications 1 à 2, dans lequel ladite source de lumière est agencée de manière à émettre de la lumière dans une direction opposée audit appareil sous test.

4. Dispositif selon l'une des revendications 1 à 3, dans lequel ladite source de lumière est apte à émettre de la lumière depuis une surface variable en fonction du champ électromagnétique mesuré par ledit capteur électromagnétique.

5. Dispositif selon l'une des revendications 1 à 4, dans lequel lesdits moyens d'entraînement sont aptes à entraîner ledit support en rotation autour dudit appareil sous test à une vitesse suffisante pour que la fréquence de passage d'un moins une source de lumière en un point donné soit supérieure à 24 Hz.

6. Dispositif selon l'une des revendications 1 à 5, dans lequel ledit capteur électromagnétique et ladite source de lumière sont agencés dans un boîtier (7, 107) apte à être fixé sur ledit support.

7. Dispositif selon la revendication 6, **caractérisé par le fait que** ledit support présente des pistes électriques (123), ledit boîtier présentant des contacteurs (124, 125) en contact avec lesdites pistes.

8. Dispositif selon l'une des revendications 1 à 7, dans lequel ledit support présente au moins une portion de forme circulaire, lesdits moyens d'entraînement étant agencés de sorte que la rotation dudit support génère une surface sensiblement sphérique.

9. Dispositif selon l'une des revendications 1 à 7, dans lequel ledit support présente une portion de forme rectiligne, lesdits moyens d'entraînement étant agencés de sorte que la rotation dudit support génère une surface sensiblement cylindrique de révolution.

10. Dispositif selon l'une des revendications 1 à 9, comprenant un plateau (12) pour ledit appareil sous test, ledit plateau étant fixé à l'extrémité d'un tube creux (13).

11. Dispositif selon l'une des revendications 1 à 10, comprenant une armature fixe (2) à laquelle est relié ledit support par l'intermédiaire de paliers creux (4).

12. Dispositif selon l'une des revendications 1 à 11, comprenant une cage réalisée au moins partiellement en matériau transparent, ledit support étant agencé dans ladite cage.

13. Dispositif selon l'une des revendications 1 à 12, dans lequel ladite source de lumière est reliée audit capteur électromagnétique par l'intermédiaire de moyens de conversion (10, 110).

14. Dispositif selon la revendication 13, dans lequel lesdits moyens de conversion sont commutables entre plusieurs états, ledit dispositif de mesure comprenant des moyens de commande (18) aptes à communiquer avec lesdits moyens de conversion par l'intermédiaire de moyens de communication pour commuter lesdits moyens de conversion.

15. Dispositif selon la revendication 13, dans lequel lesdits moyens de conversion sont choisis en fonction d'une norme de compatibilité électromagnétique, ledit dispositif de mesure comprenant une source de signal reliée audits moyens de conversion et apte à émettre un signal de non-conformité quand le champ électromagnétique mesuré par ledit capteur électromagnétique indique que l'appareil sous test n'est pas conforme à ladite norme.

16. Utilisation d'un dispositif selon l'une des revendications 1 à 15, comprenant le fait d'entraîner ledit support en rotation autour dudit appareil sous test à une vitesse suffisante pour que la fréquence de passage d'un moins une source de lumière en un point donné soit supérieure à 24 Hz.

17. Utilisation d'un dispositif selon la revendication 15, comprenant le fait de vérifier si un appareil sous test est conforme à ladite norme, puis le fait de remplacer ledit support par un deuxième support dans lequel lesdits moyens de conversion sont choisis en fonction d'une deuxième norme, et vérifier si ledit appareil sous test est conforme à ladite deuxième norme.

## Patentansprüche

1. Vorrichtung (1) zur Messung des elektromagnetischen Felds, das von einer im Test befindlichen Vorrichtung (11, 14) emittiert wird, umfassend einen Träger (3, 103), der in Bezug auf die im Test befindliche Vorrichtung bewegbar ist, mindestens einen elektromagnetischen Sensor (8, 108), der am Träger befestigt ist, und Antriebsmittel (5, 6), die geeignet sind, den Träger um die im Test befindliche Vorrichtung in Drehung zu versetzen, **dadurch gekennzeichnet, dass** diese mindestens eine Lichtquelle (9, 109) umfasst, die benachbart dem elektromagnetischen Sensor befestigt ist und Licht als Funktion des elektromagnetischen Felds emittiert, das von dem elektromagnetischen Sensor gemessen wird.

2. Vorrichtung gemäß Anspruch 1, umfassend eine Vielzahl von elektromagnetischen Sensoren, die am Träger befestigt sind, und eine Vielzahl von Lichtquellen, die jeweils einem der elektromagnetischen Sensoren benachbart und geeignet sind, Licht als Funktion des elektromagnetischen Felds zu emittieren, das von dem benachbarten elektromagnetischen Sensor gemessen wird.

3. Vorrichtung gemäß einem der Ansprüche 1 bis 2, wobei die Lichtquelle eingerichtet ist, Licht in einer Richtung entgegengesetzt zur im Test befindlichen Vorrichtung zu emittieren.

4. Vorrichtung gemäß einem der Ansprüche 1 bis 3, wobei die Lichtquelle geeignet ist, das Licht von einer variablen Fläche als Funktion des elektromagnetischen Felds zu emittieren, das von dem elektromagnetischen Sensor gemessen wird.

5. Vorrichtung gemäß einem der Ansprüche 1 bis 4, wobei die Antriebsmittel geeignet sind, den Träger um die im Test befindliche Vorrichtung in Drehung mit einer Geschwindigkeit zu versetzen, die ausreicht, damit die Durchlassfrequenz mindestens einer Lichtquelle an einem gegebenen Punkt größer als 24 Hz ist.

6. Vorrichtung gemäß einem der Ansprüche 1 bis 5, wobei der elektromagnetische Sensor und die Lichtquelle in einem Gehäuse (7, 107) eingerichtet sind, das geeignet ist, auf dem Träger befestigt zu werden.

7. Vorrichtung gemäß Anspruch 6, **dadurch gekennzeichnet, dass** der Träger elektrische Leiterbahnen (123) aufweist, wobei das Gehäuse Schalter (124, 125) in Kontakt mit den Bahnen aufweist.

8. Vorrichtung gemäß einem der Ansprüche 1 bis 7, wobei der Träger mindestens einen kreisförmigen Abschnitt aufweist, wobei die Antriebsmittel derart eingerichtet sind, dass die Drehung des Trägers eine im Wesentlichen sphärische Form generiert.

9. Vorrichtung gemäß einem der Ansprüche 1 bis 7, wobei der Träger mindestens einen geraden Abschnitt aufweist, wobei die Antriebsmittel derart eingerichtet sind, dass die Drehung des Trägers eine im Wesentlichen zylindrische Drehfläche generiert.

10. Vorrichtung gemäß einem der Ansprüche 1 bis 9, umfassend eine Platte (12) für die im Test befindliche Vorrichtung, wobei die Platte am Ende eines hohlen Rohrs (13) befestigt ist.

11. Vorrichtung gemäß einem der Ansprüche 1 bis 10, umfassend ein festes Gestell (2), mit dem der Träger durch Hohllager (4) verbunden ist.

12. Vorrichtung gemäß einem der Ansprüche 1 bis 11, umfassend einen Käfig, der mindestens teilweise aus einem transparenten Material hergestellt ist, wobei der Träger in dem Käfig eingerichtet ist.

13. Vorrichtung gemäß einem der Ansprüche 1 bis 12, wobei die Lichtquelle mit dem elektromagnetischen Sensor durch Wandlermittel (10, 110) verbunden ist.

14. Vorrichtung gemäß Anspruch 13, wobei die Wandlermittel zwischen mehreren Zuständen umschaltbar sind, wobei die Messvorrichtung Steuermittel (18) umfasst, die geeignet sind, mit den Wandlermitteln durch Kommunikationsmittel zu kommunizieren, um die Wandlermittel umzuschalten.

15. Vorrichtung gemäß Anspruch 13, wobei die Wandlermittel gemäß einer elektromagnetischen Kompatibilitätsnorm ausgewählt sind, wobei die Messvorrichtung eine Signalquelle umfasst, die mit den Wandlermitteln verbunden ist und geeignet ist, ein Nicht-Konformitätssignal auszugeben, wenn das elektromagnetische Feld, das von dem elektromagnetischen Sensor gemessen wird, anzeigt, dass die im Test befindliche Vorrichtung mit der Norm nicht konform ist.

16. Verwendung einer Vorrichtung gemäß einem der Ansprüche 1 bis 15, umfassend das Antreiben des Trägers in Drehung um die im Test befindliche Vorrichtung mit einer Geschwindigkeit, die ausreicht, damit die Durchgangsfrequenz mindestens einer Lichtquelle an einem gegebenen Punkt größer ist als 24 Hz.

17. Verwendung einer Vorrichtung gemäß Anspruch 15, umfassend das Verifizieren, ob die im Test befindliche Vorrichtung mit der Norm konform ist, dann das Ersetzen des Trägers durch einen zweiten Träger, wobei die Wandlermittel gemäß einer zweiten Norm ausgewählt sind, und das Verifizieren, ob die im Test befindliche Vorrichtung mit der zweiten Norm konform ist.

## Claims

1. A device (1) for measuring the electromagnetic field emitted by a tested apparatus (11, 14), including a support (3, 103) that is movable relative to said tested apparatus, at least one electromagnetic sensor (8, 108) fastened to said support and driving means (5, 6) able to drive the rotation of said support around said tested apparatus, **characterized in that** it includes at least one light source (9, 109) fastened adjacent to said electromagnetic sensor and emitting light based on the electromagnetic field measured by said electromagnetic sensor.

2. The device according to claim 1, including a plurality of electromagnetic sensors fastened to said support, and a plurality of light sources respectively adjacent to one electromagnetic sensors and capable of emitting light as a function of the electromagnetic field measured by the adjacent electromagnetic sensor.

3. The device according to one of claims 1 to 2, wherein said light source is arranged so as to emit light in a direction opposite said tested apparatus.

4. The device according to one of claims 1 to 3, wherein said light source is able to emit light from a variable surface as a function of the electromagnetic field measured by said electromagnetic sensor.

5. The device according to one of claims 1 to 4, wherein said driving means are able to drive the rotation of said support around said tested apparatus at a speed sufficient for the passage frequency of at least one light source by a given point to be greater than 24 Hz.

6. The device according to one of claims 1 to 5, wherein said electromagnetic sensor and said light source are arranged in a housing (7, 107) able to be fastened on said support.

7. The device according to claim 6, **characterized in that** said support has electrical tracks (123), said housing having contactors (124, 125) in contact with said tracks.

8. The device according to one of claims 1 to 7, in which said support has at least one circular portion, said driving means being arranged such that the rotation of said support generates a substantially spherical surface.

9. The device according to one of claims 1 to 7, wherein said support has a rectilinear portion, said driving means being arranged such that the rotation of said support generates a surface that is substantially cylindrical of revolution.

10. The device according to one of claims 1 to 9, including a plate (12) for said tested apparatus, said plate being fastened to the end of a hollow tube (13).

11. The device according to one of claims 1 to 10, including a fixed framework (12) to which said support is connected via hollow bearings (4).

12. The device according to one of claims 1 to 11, including a cage made at least partially from transparent material, said support being arranged in said cage.

13. The device according to one of claims 1 to 12, wherein said light source is connected to said electromagnetic sensor via conversion means (10, 110).

14. The device according to claim 13, wherein said conversion means can be switched between several states, said measuring device including control means (18) capable of communicating with said conversion means via communication means in order to switch said conversion means.

15. The device according to claim 13, wherein said conversion means are chosen based on an electromagnetic compatibility norm, said measuring device including a signal source connected to said conversion means and able to emit a noncompliance signal when the electromagnetic field measured by said electromagnetic sensor indicates that the tested apparatus is not compliant with said norm.

16. A use of a device according to one of claims 1 to 15, including driving the rotation of said support around said tested apparatus at a speed sufficient for the passage frequency of at least one light source by a given point to be greater than 24 Hz.

17. The use of a device according to claim 15, including verifying whether a tested apparatus is compliant with said norm, then replacing said support with a second support in which said conversion means are chosen based on a second norm, and verifying whether said tested apparatus is compliant with said second norm.
